# EUROPEAN PATENT SPECIFICATION

(11) **EP 2 622 661 B1**
(45) Date of publication and mention of the grant of the patent: **10.12.2014**
(21) Application number: 10857997.0
(22) Date of filing: 30.09.2010
(51) Int. Cl.: H01L 41/187, C04B 35/01, C04B 35/475

(54) **LEAD-FREE PIEZOELECTRIC MATERIAL BASED ON BISMUTH ZINC TITANATE-BISMUTH POTASSIUM TITANATE-BISMUTH SODIUM TITANATE**
BLEIFREIES PIEZOELEKTRISCHES MATERIAL AUF DER BASIS VON BISMUTZINKTITANAT-BISMUTKALIUMTITANAT-BISMUTNATRIUMTITANAT
MATÉRIAU PIÉZOÉLECTRIQUE SANS PLOMB À BASE DE TITANATE DE BISMUTH ET DE ZINC-TITANATE DE BISMUTH ET DE POTASSIUM-TITANATE DE BISMUTH ET DE SODIUM

(43) Date of publication of application: 07.08.2013
(73) Proprietor: Hewlett-Packard Development Company, L.P., Houston, TX 77070 (US)
(72) Inventor: JEON, Yu Hong, Corvallis, Oregon 97330-4239 (US); CANN, David, Corvallis, Oregon 97330-4239 (US); PATTERSON, Eric, Corvallis, Oregon 97330-4239 (US); GIBBONS, Brady, Corvallis, Oregon 97330-4239 (US); MARDILOVICH, Peter, Corvallis, Oregon 97330-4239 (US)
(74) Representative: Stöckeler, Ferdinand
(86) International application number: PCT/US2010/050947
(87) International publication number: WO 2012/044309

(56) References cited:
- WO-A1-2011/012682
- JP-A- 2002 265 262
- JP-A- 2002 321 976
- JP-A- 2007 137 704
- KR-A- 20080 004 903
- WANG L ET AL: "Dielectric and Piezoelectric Properties of lead-free BaTiO3-Bi(Zn0.5Ti0.5)O3 and (Bi0,5Na0,5)TiO3-Bi(Zn0,5Ti0,5)o3 Ceramics", FERROELECTRICS, TAYLOR & FRANCIS INC, US, vol. 380, 1 January 2009 (2009-01-01), pages 177-182, XP009139850, ISSN: 0015-0193
- CHIEN-CHIH HUANG ET AL: "Structure and ferroelectric properties of Bi(Zn 1/2 Ti 1/2 )O 3 -(Bi 1/2 K 1/2 )TiO 3 perovskite solid solutions", IEEE TRANSACTIONS ON ULTRASONICS, FERROELECTRICS AND FREQUENCY CONTROL, IEEE, US, vol. 56, no. 7, 1 July 2009 (2009-07-01), pages 1304-1308, XP011269897, ISSN: 0885-3010

## Description

### BACKGROUND

The present disclosure generally relates to piezoelectric ceramic materials, and more particularly to lead-free piezoelectric ceramic materials based on ternary compositions containing bismuth zinc titanate-bismuth potassium titanate bismuth- sodium titanate.

Piezoelectric ceramic materials (also referred to as piezoelectric ceramics or piezoceramics) have been widely used in applications such as actuators, transducers, resonators, sensors, and random access memories. Among those piezoelectric ceramics, lead zirconate titanate (PZT), and its related solid solutions are the most widely used due to their excellent piezoelectric properties and the ease with which modifications by doping can be made during manufacturing. However, there are drawbacks to using PZT which limit its desirability in many applications. One concern is its possible environmental effects due to the toxicity of highly volatile PbO which can evolve from PZT during fabrication. Another drawback of PZT piezoceramics is the strong fatigue behavior associated with PZT. Fatigue is a phenomenon in which a piezoelectric material loses its switchable polarization and electromechanical strain during electrical cyclic loading.

WANG L ET AL: "Dielectric and Piezoelectric Properties of lead-free BaTiO3-Bi(Zn0.5Ti0.5)O3 and (Bi0,5Na0,5)TiO3-Bi(Zn0,5Ti0,5)O3 Ceramics", FERRO-ELECTRICS, TAYLOR & FRANCIS INC, US, vol. 380, 1 January 2009 (2009-01-01), pages 177-182, XP009139850, ISSN: 0015-0193, describe the effects of Bi(Zn_{0.5}Ti_{0.5})O₃ substitution in (Bi_{0.5}Na_{0.5})TiO₃ piezoelectric ceramics.

CHIEN-CHIH HUANG ET AL: "Structure and ferroelectric properties of Bi(Zn1/2Ti1/2)O3-(Bi1/2K1/2)TiO3 perovskite solid solutions", IEEE TRANSACTIONS ON ULTRASONICS, FERROELECTRICS AND FREQUENCY CONTROL, IEEE, US, vol. 56, no. 7, 1 July 2009 (2009-07-01), pages 1304-1308, XP011269897, ISSN: 0885-3010, disclose piezoelectric ceramics comprising a single perovskite phase with tetragonal symmetry.

WO 2011/012682 A1 forms prior art according to Article 54(3) EPC and discloses a piezoelectric ceramic composition comprising a matrix material, which comprises at least two matrix components with a perovskite. A first matrix component is selected from (Bi_{0.5}A_{0.5}) EO₃, BaEO₃ and mixtures thereof, and a second matrix component is Bi(Me_{0,5}E_{0,5})O₃, with A being selected from an alkali metal, E being selected from titanium and zirconium independently thereof, and Me being selected from bivalent metals.

### BRIEF DESCRIPTION OF THE DRAWINGS

For a detailed description of exemplary embodiments of the invention, reference will now be made to the accompanying drawings in which:
Fig. 1 is a ternary compositional/phase diagram illustrating the composition range of piezoelectric materials according to certain embodiments.
Fig. 2 shows X-ray diffraction patterns of several embodiments of the disclosed BZT-BKT-BNT compositions, indicating that these compositions consist of a single perovskite phase.
Fig. 3 is a graph of polarization and electromechanical strain values at applied electrical fields ranging from -60 kV/cm to 60 kV/cm of a BZT-BKT-BNT composition according to an embodiment of the disclosed compositions.
Fig. 4 is a graph of polarization and electromechanical strain values at applied electrical fields ranging from -60 kV/cm to 60 kV/cm of another BZT-BKT-BNT composition according to an embodiment of the disclosed compositions.
Fig. 5 is a graph of electromechanical strain values (% of maximum strain) under a unipolar electrical field of 60 kV/cm of a BZT-BKT-BNT composition according to an embodiment of the disclosed compositions.
Fig. 6 is a graph of electromechanical strain values under bipolar applied electrical fields ranging from -60 kV/cm to 60 kV/cm of a BZT-BKT-BNT composition according to according to an embodiment of the disclosed compositions.

### NOTATION AND NOMENCLATURE

Certain terms are used throughout the following description and claims. In the following description and in the claims, the terms "including" and "comprising" are used in an open-ended fashion, and thus should be interpreted to mean "including, but not limited to...."

The term "Curie temperature" refers to the temperature above which a piezoelectric material loses its spontaneous polarization and piezoelectric characteristics.

The term "polarization hysteresis" refers to lead-free piezoelectric ceramic materials that display non-linear polarization characteristics indicative of a polar state.

The term "electromechanical strain" refers to an electric field induced strain and is commonly expressed in terms of one or more piezoelectric coefficients (d₃₃ and d₃₁, for example), where dᵢⱼ (units pm/V) is the tensor property that relates the strain to the applied electric field (V/m). The d₃₃ coefficient can be measured in many different ways, such a piezoelectric resonance, the direct piezoelectric effect, the indirect piezoelectric effect, and others. In the context of this disclosure, the d₃₃ coefficient is calculated as the ratio between the maximum electromechanical strain and the applied electric field (d₃₃ = Sₘₐₓ/Eₘₐₓ). Sometimes this is described as the effective piezoelectric coefficient or the normalized strain or d₃₃*. An example of its use is given in Y. Hiruma et al., J. Appl. Phys. 103:084121 (2008).

In the context of piezoelectric ceramic materials, the term "fatigue" refers to the observed loss of polarization and electromechanical strain after the application of a cyclic electric field.

The relative amounts or proportions of the components in a lead-free piezoelectric material are expressed in terms of either mole fraction or mole percent (mol%), as for example, 0.01 ≤ x ≤ 0.1, 0.3 ≤ y ≤ 0.5, and 0.4 ≤ z ≤ 0.6, or 10BZT-30BKT-60BNT.

The term "about" when referring to a numerical value or range is intended to include larger or smaller values resulting from experimental error that can occur when taking measurements. Such measurement deviations are usually within plus or minus 10 percent of the stated numerical value.

Temperature, ratios, concentrations, amounts, and other numerical data may be presented herein in a range format. It is to be understood that such range format is used merely for convenience and brevity and should be interpreted flexibly to include not only the numerical values explicitly recited as the limits of the range, but also to include all the individual numerical values or sub-ranges encompassed within that range, as if each numerical value and sub-range is explicitly recited. For example, a temperature range of about 100°C to about 500°C should be interpreted to include not only the explicitly recited limits of 100°C and 500°C, but also to include every intervening temperature such as 250°C, 300°C, 350°C and 400°C, and all sub-ranges such as 300°C to 400°C, and so forth.

### DETAILED DESCRIPTION

The following discussion is directed to various embodiments of the invention. The embodiments disclosed should not be interpreted, or otherwise used, as limiting the scope of the disclosure, including the claims. In addition, one skilled in the art will understand that the following description has broad application, and the discussion of any embodiment is meant only to be exemplary of that embodiment, and not intended to intimate that the scope of the disclosure, including the claims, is limited to that embodiment. The current invention is directed to a lead-free piezoelectric ceramic material according to the independent claim 1.

Lead-Free Piezoelectric Ceramics

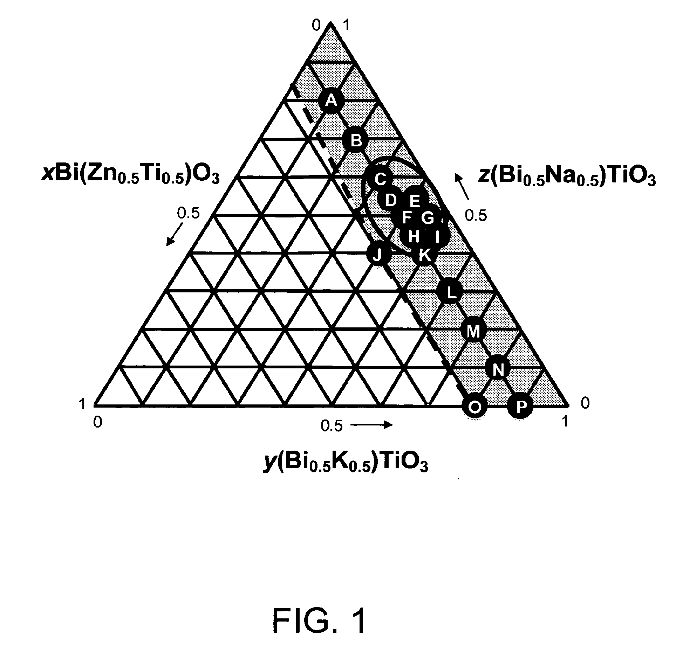

Referring to Fig. 1, a ternary composition/phase diagram illustrates the entire range of lead-free piezoelectric ceramic materials based on ternary compositions in the Bi(Zn_{0.5}Ti_{0.5})O₃-(Bi_{0.5}K_{0.5})TiO₃-(Bi_{0.5}Na_{0.5})Ti≤₃ system (also sometimes referred to herein as BZT-BKT-BNT). For example, a lead-free piezoelectric ceramic material may have the general chemical formula xBi(Zn_{0.5}Ti_{0.5})O₃-*y*(Bi_{0.5}K_{0.5})TiO₃-*z*(Bi_{0.5}Na_{0.5})TiO₃, wherein *x*+*y*+*z*=*1* and x, *y, z ≠* 0. The compositions having stoichiometries on the left side of the dashed line in Fig. 1 are generally less stable perovskite structures and may include multiple phases. The compositions having stoichiometries in the shaded region to the right of the dashed line in Fig. 1 are generally solid solutions having a more stable single phase perovskite structure at standard atmospheric conditions. The shaded region in Fig. 1 includes lead-free piezoelectric ceramic materials having the aforesaid general chemical formula , exclusive of materials wherein 0.20 ≤ x ≤ 0.18, 0.01 ≤ y ≤ 0.30, and 0.50 ≤ z ≤ 0.99. Those compositions include, but are not limited to, A-I and K-N, which are also described in Table 1. In the embodiments of the present invention, the lead-tree piezoelectric ceramic material has the aforesaid general chemical formula wherein 0< x ≤ 0.19, y = 0.28 - 0.50 and z = 0.40 - 0.65, corresponding to the ternary compositions enclosed by the ellipse in Fig. 1. Those compositions include, but are not limited to, C-K, which are also described in Table 1. The stoichiometries of some representative BZT-BKT-BNT materials with single phase stable perovskite structures are shown in mole percent in Table 1, and are identified as A-N in Fig. 1. The compositions represented by "O" and "P" are binary compositions which are included in Fig. 1 and Table 1 for comparative purposes.

**TABLE 1**

| Identifier | Bi(Zn_{0.5}Ti_{0.5})O₃ (Mol%) | (Bi_{0.5}K_{0.5})TiO₃ (Mol%) | (Bi_{0.5}Na_{0.5})TiO₃ (Mol%) |
|---|---|---|---|
| A | 10 | 10 | 80 |
| B | 10 | 20 | 70 |
| C | 10 | 30 | 60 |
| D | 10 | 35 | 55 |
| E | 5 | 40 | 55 |
| F | 10 | 40 | 50 |
| G | 5 | 45 | 50 |
| H | 10 | 45 | 45 |
| I | 5 | 50 | 45 |
| J | 20 | 40 | 40 |
| K | 10 | 50 | 40 |
| L | 10 | 60 | 30 |
| M | 10 | 70 | 20 |
| N | 10 | 80 | 10 |
| O | 20 | 80 | 0 |
| P | 10 | 90 | 0 |

The compositions identified as C-I and K in Table 1, which are representative of the compositions enclosed by a black ellipse in Fig. 1, have the highest strain values of these stable single phase perovskites, demonstrating maximum electromechanical strain coefficients (d₃₃) in the range of about 200 pm/V to about 700 pm/V. In some embodiments, a BZT-BKT-BNT composition has a d₃₃ coefficient in the range of about 400 pm/V to about 650 pm/V.

The Curie temperature (T_{c}) of most BZT-BKT-BNT compositions is in the range of about 100°C and about 500°C. In some cases the T_{c} of a composition is between about 300°C and about 400°C. The relative proportions of BZT, BKT and BNT may be varied during production of the ternary composition so that the product will have a specified Curie temperature range. Depending upon the desired end use of the composition, the operating temperature of the ceramic product may differ from the Tc of the BZT-BKT-BNT composition. For example, in some situations the operating temperature will be about 100°C-150°C lower than the T_{c}. As a practical matter, maximum operating temperature of a BZT-BKT-BNT ceramic product is its depolarization temperature.

Polarization hysteresis data for representative compositions indicate ferroelectric behavior, and a plot of the electric field induced strain appears as butterfly loops, consistent with other ferroelectric materials. Many of these compositions have properties similar to or exceeding those of the BKT-BNT and BKT-BZT binary systems. Table 2 shows piezoelectric data for some BNT-BKT and BKT-BZT binary compositions.

**TABLE 2**

| Piezoelectric data on BNT-BKT and BZT-BKT compositions | | | |
|---|---|---|---|
| Material | d₃₃* (pm/V) | T_{c} (°C) | Reference |
| 80BNT-20BKT | 240 | 280-300 | Rödel et al., J. Am. Ceram. Soc. 92 [6] (2009) pp. 1153-1177. |
| 10BZT-90BKT | 235 | 250-300 | C.-C. Huang, et al., IEEE Trans. UFFC 56 [7] (2009) pp. 1304-1308. |

In some embodiments, a lead-free piezoelectric ceramic material has the general chemical formula *x*Bi(Zn_{0.5}Ti_{0.5})O₃-*y*(Bi_{0.5}K_{0.5})TiO₃-*z*(Bi_{0.5}Na_{0.5})TiO₃, wherein *x*+*y*+*z*=*1* and x, *y, z ≠* 0. In many embodiments, this ceramic material is a solid solution having a stable perovskite structure at standard atmospheric conditions.

In some embodiments, a disclosed lead-free piezoelectric ceramic material has the proportions 0.01 ≤ x ≤ 0.1, 0.3 ≤ y ≤ 0.5, and 0.4 ≤ z ≤ 0.6.

Properties of the BZT-BKT-BNT materials may be evaluated by piezoelectric resonance measurements following the customary IEEE standard, poling studies to measure the low-field electromechanical strain coefficient d₃₃, fatigue measurements, and studies of the temperature dependence of these piezoelectric properties. Polarization hysteresis data for representative compositions indicate ferroelectric behavior and the electric field induced strain appears as the expected butterfly loops. Excellent fatigue resistance exists for many of the BZT-BKT-BNT piezoelectric ceramics, with losses of ≤ 1 percent of the maximum polarization after 1 million cycles in many cases. This compares quite favorably to the fatigue behavior of conventional PZT materials. The piezoelectric strain coefficients (d₃₃ and d₃₁) of BZT-BKT-BNT compositions are generally below those of PZT. By way of comparison, conventional PZT piezoelectric ceramics typically demonstrate the following properties of piezoelectric resonance, low-field d₃₃, fatigue and temperature dependence of piezoelectric properties: εᵣ about 1000 - 3400; d₃₃ about 200 pm/V - 600 pm/V; k₃₃ about 0.64 - 0.75; and T_{c} about 195°C - 365°C.

In some embodiments, a disclosed BZT-BKT-BNT piezoelectric ceramic material demonstrates a piezoelectric strain coefficient (d₃₃) equal to or exceeding that of a lead zirconate titanate perovskite. In some embodiments, the ceramic material has a maximum electromechanical strain value in the range of about 0.20 percent to about 0.35 percent elongation under electric field.

In some embodiments, a disclosed lead-free piezoelectric ceramic material demonstrates fatigue resistance exceeding that of a lead zirconate titanate perovskite. In some embodiments, a BZT-BKT-BNT piezoelectric ceramic material demonstrates a maximum high-field piezoelectric d₃₃ value in the range of about 200 pm/V to about 700 pm/V, and in some cases is in the range of about 400 pm/V to about 650 pm/V.

For many applications in which fatigue resistance of the piezoelectric ceramic is more important than the piezoelectric maximum strain performance, a disclosed BZT-BKT-BNT ceramic material may be advantageous. Many of the BZT-BKT-BNT compositions will meet or exceed the piezoelectric properties of doped PZT materials, and will provide a constant strain with minimal or no degradation over the life of a device employing such material. Many BZT-BKT-BNT ceramic materials with improved piezoelectric properties are substantially equivalent or superior to conventional PZT-based piezoelectric ceramics and have similar potential uses, including but not limited to actuators, transducers, resonators, sensors, and random access memories. Some of these applications will further benefit from the absence of lead in the piezoelectric ceramics.

### Production of Lead-Free Piezoelectric Ceramics

### A. Ceramic Discs

All lead-free BZT-BKT-BNT compositions described herein may be produced by any suitable solid-state synthesis method, using Bi₂O₃, NaCO₃, KCO₃, ZnO, and TiO₂ starting powders of at least 99% purity. The Curie temperature (T_{c}) of the resulting product is generally between about 100°C and about 500°C. The T_{c} of a piezoelectric ceramic may be increased or decreased by varying the relative amounts of the starting powders. The relative amounts of BZT, BKT and BNT may be adjusted so that the product will have a T_{c} in a specified range. In accordance with conventional solid state synthesis methods for making ceramic materials, the powders are milled, shaped and calcined to produce the desired ceramic product. Milling can be either wet or dry type milling, as is known in the art. High energy vibratory milling may be used, for instance, to mix starting powders and for post-calcination grinding. The powders are mixed with a suitable liquid (*e.g*., ethanol or water, or a combination of liquids) and wet milled with a suitable high density milling media (*e.g*., yttria stabilized zirconia (YSZ) beads). The milled powders are calcined, then mixed with a binder, formed into the desired shape (*e.g*., pellets) and sintered to produce a ceramic product with high sintered density. For testing purposes, prior to electrical measurements the ceramic disc may be polished to a suitable thickness (*e.g.,* 0.9 mm), and a silver paste (*e.g.*, Heraeus C1000) is applied to both sides of the discs. Depending upon the intended end use, a high-density BZT-BKT-BNT ceramic disc or pellet may be polished to a thickness in the range of about 0.5 µm to about 1 µm, suitable for use as a piezoelectric actuator, for example.

### B. Ceramic Thin Film

When the intended use of the BZT-BKT-BNT ceramic material requires a thin film product, the production method may be modified to include chemical solution deposition using chemical precursors such bismuth nitrate, titanium isopropoxide, etc., or sputtering using solid state sintered or hot-pressed ceramic targets. Any suitable sputtering or chemical deposition method may be used for this purpose. The resulting thin film ceramic may have a thickness in the range of about 50 nm to about 10 µm, in some cases.

### C. Piezoelectric composites

For end uses such as sensors or transducers, which require the use piezoelectric composites, the above-described sintered BZT-BKT-BNT ceramic material can be modified for this purpose. The ceramic powder is ground or milled to the desired particle size and loaded into polymer matrix to create a 0-3 piezoelectric composite. The ceramic powder can be formed into sintered rods or fibers using injection molding or similar technique and loaded into a polymer matrix to create a 1-3 piezoelectric composite. The polymer may be piezoelectric, such as PVDF, or non-piezoelectric such as epoxy depending on the final application.

### EXAMPLES

### Example 1: Production of BZT-BKT-BNT Compositions

Lead-free ternary compositions were produced via solid-state synthesis methods, using Bi₂O₃, NaCO₃, KCO₃, ZnO, and TiO₂ starting powders of at least 99% purity. Appropriate amounts of those powders were combined to yield BZT-BKT-BNT compositions having the following relative proportions (mole percent): 10-30-60, 10-35-55, 10-40-50, 10-45-45, 5-35-60, 5-40-55, and 5-45-50. Six hours of high energy vibratory milling was used for mixing starting powders and for post-calcination grinding. Ethanol mixtures containing 15 vol.% powder were milled with high density YSZ beads approximately 3/8 inch in diameter. After removal of YSZ, calcination was performed on the milled powder in covered crucibles at 900°C for 6 hours. The calcined powders were mixed with a 3 wt.% solution of Polyvinyl Butyral (PVB) binder, and the powders were uniaxially cold pressed into 12.7 mm pellets at a pressure of 150 MPa. Following a 400°C binder burnout, the pellets were sintered in covered crucibles at 1100°C for 2 hours (5% BZT) or 1050°C for 5 hours (10% BZT). Prior to electrical measurements, the ceramics discs were polished to thickness of 0.9 mm with smooth and parallel surfaces. Silver paste (Heraeus C1000) was fired on both sides in air at 650°C for 30 minutes.

### Example 2: Measurement of Piezoelectric and Electric-field Induced Strain Properties of BKT-BNT-BZT Compositions.

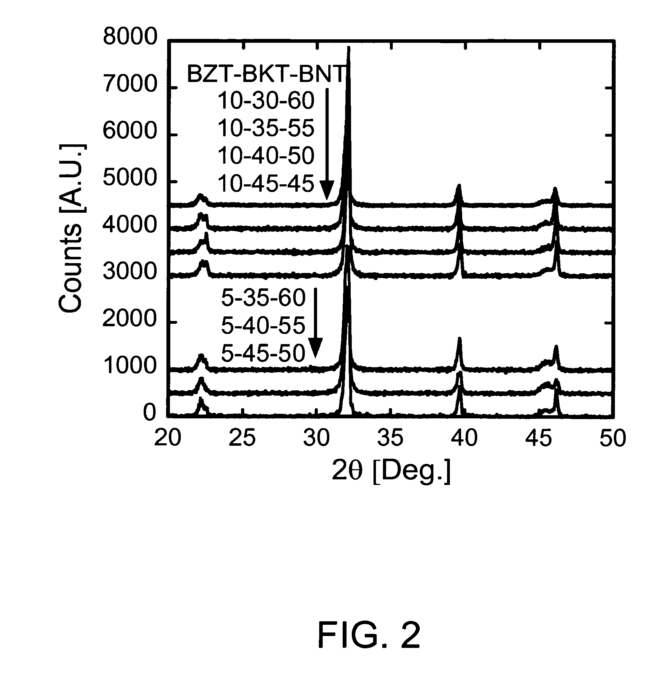

The BZT-BKT-BNT compositions of Example 1 were subjected to X-ray diffraction testing, and the resulting XRD patterns are shown in Fig. 2, indicating a single phase perovskite structure for representative BZT-BKT-BNT compositions having the following relative proportions: 10-30-60, 10-35-55, 10-40-50, 10-45-45, 5-35-60, 5-40-55, and 5-45-50. There was no evidence of any secondary phases in those compositions.

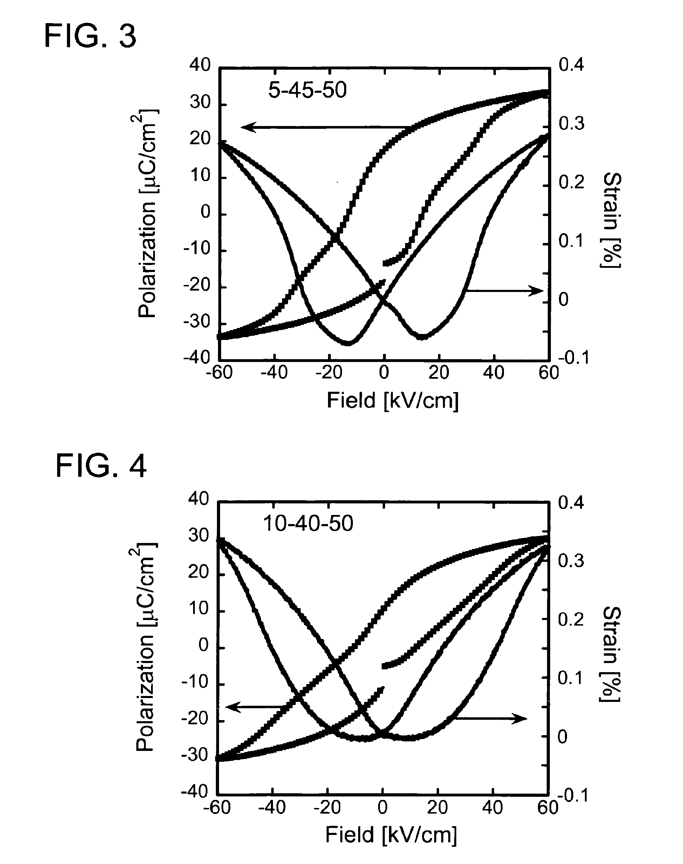

Figs. 3 and 4 show polarization and electromechanical strain values at applied (bipolar) electrical fields ranging from -60 kV/cm to 60 kV/cm of a BZT-BKT-BNT composition having the relative proportions 5-45-50 (Fig. 3) and 10-40-50 (Fig. 4). The arrows on the figure indicate the data for polarization and for strain. The data show a gradual shift from ferroelectric-like behavior in Fig. 3, with some degree of polarization remanence and well-formed "butterfly"-like strain loops that are a characteristic of ferroelectric materials. In contrast, at a higher BZT content (Fig. 4) we observe a decrease in remanence and the strain loops become more parabolic in nature. The polarization was measured using a Radiant Premier II Ferroelectric Test System which utilizes a Sawyer-Tower circuit. The electromechanical strain was measured using an optical interferometer directly integrated with the Radiant instrument.

### Example 3: Electric-field Induced Strain on BZT-BKT-BNT.

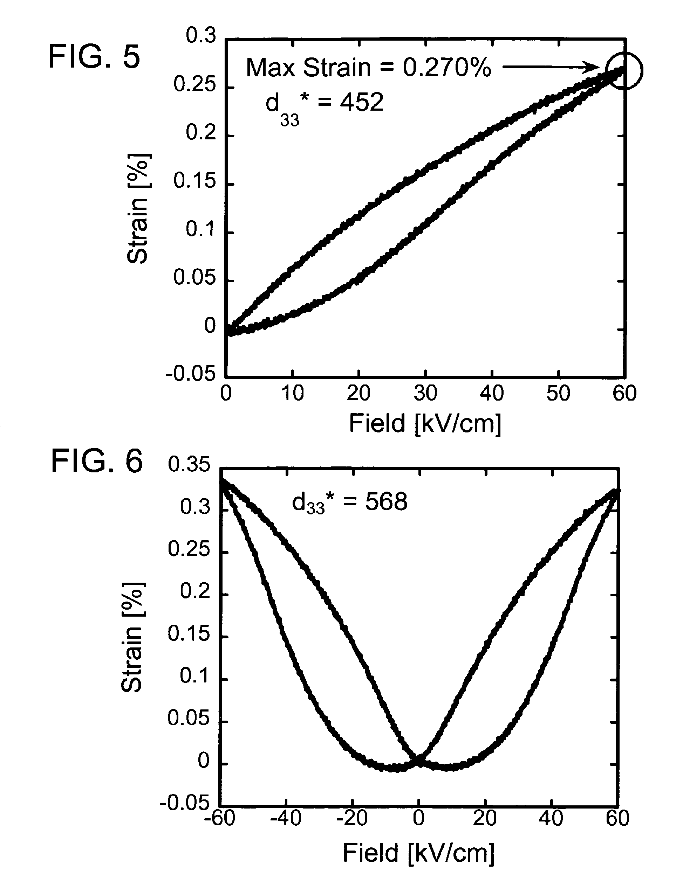

A 0.1 Bi(Zn_{0.5}Ti_{0.5})O₃-0.4 (Bi_{0.5}K_{0.5})TiO₃-0.5 (Bi_{0.5}Na_{0.5})TiO₃ ceramic (composition "F" in Table 1 and Fig. 1) was prepared as described in Example 1, and its piezoelectric properties and electric field-induced strain were assessed as described in Example 2. As shown in Fig. 5, a maximum strain of 0.27% was obtained under a unipolar driving electric field of 60 kV/cm, which is analogous to the typical operating conditions of a Hewlett-Packard piezoelectric inkjet print head. The effective d₃₃ coefficients, calculated by the ratio of the maximum strain at maximum electric field, was 452 pm/V under a unipolar field (Fig. 5) and 568 pm/V under a bipolar field (Fig. 6). Direct measurement of coefficient d₃₃ of a ceramic material may also be performed by dual-beam laser interferometer. The measured strain values under bipolar electric field for this and other representative BZT-BKT-BNT ceramics are well above the best values for other known Pb-free compositions (d₃₃ about 300 pm/V to about 400 pm/V), and are comparable to doped PZT ceramics (d₃₃ about 400 pm/V to about 600 pm/V). The depolarization temperature of the 0.1Bi(Zn_{0.5}Ti_{0.5})O₃-0.4(Bi_{0.5}K_{0.5})TiO₃-0.5(Bi_{0.5}Na_{0.5})TiO₃ ceramic, and that of other representative BZT-BKT-BNT ceramics, is 200°C or higher, or at least equal to doped PZT materials.

The above discussion is meant to be illustrative of the principles and various embodiments of the present invention. Numerous variations and modifications will become apparent to those skilled in the art once the above disclosure is fully appreciated. It is intended that the following claims be interpreted to embrace all such variations and modifications.

## Claims

1. A lead-free piezoelectric ceramic material having the general chemical formula:
*x*Bi(Zn_{0.5}Ti_{0.5})O₃-*y*(Bi_{0.5}K_{0.5})TiO₃-*z*(Bi_{0.5}Na_{0.5})TiO₃
wherein *x*+*y*+*z*=*1* and x, *y, z ≠* 0,
wherein 0.01 < x ≤ 0.19, 0.28 ≤ y ≤ 0.50 and 0.40 ≤ z ≤ 0.65.

2. The ceramic material of claim 1, wherein said material comprises a solid solution having a stable perovskite structure at standard atmospheric conditions.

3. The lead-free piezoelectric ceramic material of claim 1, wherein said ceramic material has a piezoelectric strain coefficient d₃₃ equal to or exceeding that of a lead zirconate titanate perovskite.

4. The lead-free piezoelectric ceramic material of claim 1, wherein said ceramic material has a maximum piezoelectric d₃₃ value in the range of 200 pm/V to 700 pm/V.

5. The lead-free piezoelectric ceramic material of claim 1, wherein said ceramic material has a maximum piezoelectric d₃₃ value in the range of 400 pm/V to 650 pm/V.

6. The lead-free piezoelectric ceramic material of claim 1, wherein said ceramic material has a maximum electromechanical strain value in the range of 0.20 percent to 0.35 percent.

7. The lead-free piezoelectric ceramic material of claim 1, wherein said ceramic material has fatigue resistance equal to or exceeding that of a lead zirconate titanate perovskite.

8. The lead-free piezoelectric ceramic material of claim 1 having a Curie temperature (T_{c}) in the range of 100°C to 500°C.

9. The lead-free piezoelectric ceramic material of claim 8 wherein the Curie temperature is in the range of 300°C to 400°C.

## Patentansprüche

1. Bleifreies Piezokeramikmaterial mit der folgenden allgemeinen chemischen Formel:
*x*Bi(Zn_{0,5}Ti_{0,5})O₃-*y*(Bi_{0,5}K_{0,5})TiO₃-*z*(Bi_{0,5}Na_{0,5})TiO₃,
wobei x + *y* + z = 1 und x, *y, z* ≠ 0,
wobei 0,01 < x ≤ 0,19, 0,28 ≤ y ≤ 0,50 und 0,40 ≤ z ≤ 0,65.

2. Keramikmaterial nach Anspruch 1, wobei das Material eine feste Lösung mit einer stabilen Perowskitstruktur bei atmosphärischen Standardbedingungen umfasst.

3. Bleifreies Piezokeramikmaterial nach Anspruch 1, wobei das Keramikmaterial einen piezoelektrischen Belastungskoeffizienten d₃₃ hat, der dem eines Blei-Zirkonat-Titanat-Perowskiten gleich ist oder diesen übersteigt.

4. Bleifreies Piezokeramikmaterial nach Anspruch 1, wobei das Keramikmaterial einen maximalen piezoelektrischen d₃₃-Wert im Bereich von 200 pm/V bis 700 pm/V hat.

5. Bleifreies Piezokeramikmaterial nach Anspruch 1, wobei das Keramikmaterial einen maximalen piezoelektrischen d₃₃-Wert im Bereich von 400 pm/V bis 650 pm/V hat.

6. Bleifreies Piezokeramikmaterial nach Anspruch 1, wobei das Keramikmaterial einen maximalen elektromechanischen Belastungswert im Bereich von 0,20 Prozent bis 0,35 Prozent hat.

7. Bleifreies Piezokeramikmaterial nach Anspruch 1, wobei das Keramikmaterial eine Ermüdungsbeständigkeit hat, die der eines Blei-Zirkonat-Titanat-Perowskiten gleich ist oder diese übersteigt.

8. Bleifreies Piezokeramikmaterial nach Anspruch 1 mit einer Curie-Temperatur (T_{c}) im Bereich von 100 °C bis 500 °C.

9. Bleifreies Piezokeramikmaterial nach Anspruch 8, wobei die Curie-Temperatur im Bereich von 300 °C bis 400 °C liegt.

## Revendications

1. Matériau céramique piézoélectrique exempt de plomb ayant la formule chimique générale :
*x*Bi(Zn_{0.5}Ti_{0.5})O₃-*y*(Bi_{0.5}K_{0.5})TiO₃-*z*(Bi_{0.5}Na_{0.5})TiO₃
dans laquelle x + *y* + z = 1 et x, *y, z ≠* 0,
dans laquelle 0,01 < x ≤ 0,19, 0,28 ≤ y ≤ 0,50 et 0,40 ≤ z ≤ 0,65.

2. Matériau céramique selon la revendication 1, dans lequel ledit matériau comprend une solution solide ayant une structure pérovskite stable dans des conditions atmosphériques standards.

3. Matériau céramique piézoélectrique exempt de plomb selon la revendication 1, dans lequel ledit matériau céramique a un coefficient de déformation piézoélectrique d₃₃ égal à ou dépassant celui d'une pérovskite de zirconate titanate de plomb.

4. Matériau céramique piézoélectrique exempt de plomb selon la revendication 1, dans lequel ledit matériau céramique a une valeur d₃₃ piézoélectrique maximale se situant dans la plage allant de 200 pm/V à 700 pm/V.

5. Matériau céramique piézoélectrique exempt de plomb selon la revendication 1, dans lequel ledit matériau céramique a une valeur d₃₃ piézoélectrique maximale se situant dans la plage allant de 400 pm/V à 650 pm/V.

6. Matériau céramique piézoélectrique exempt de plomb selon la revendication 1, dans lequel ledit matériau céramique a une valeur de déformation électromécanique maximale se situant dans la plage allant de 0,20 pour cent à 0,35 pour cent.

7. Matériau céramique piézoélectrique exempt de plomb selon la revendication 1, dans lequel ledit matériau céramique a une résistance à la fatigue égale à ou dépassant celle d'une pérovskite de zirconate titanate de plomb.

8. Matériau céramique piézoélectrique exempt de plomb selon la revendication 1 ayant une température de Curie (T_{c}) se situant dans la plage allant de 100°C à 500°C.

9. Matériau céramique piézoélectrique exempt de plomb selon la revendication 8, dans lequel la température de Curie est se situe dans la plage allant de 300°C à 400°C.
